# EUROPEAN PATENT APPLICATION

(11) **EP 4 589 666 A1**
(43) Date of publication of application: **23.07.2025**
(21) Application number: 23865819.9
(22) Date of filing: 12.09.2023
(51) Int. Cl.: H01L 31/18, H01L 31/05

(54) **TABBING DEVICE AND TABBING METHOD**

(30) Priority: 13.09.2022 KR 20220114944; 13.09.2022 KR 20220114945
(71) Applicant: Hanwha Solutions Corporation, Seoul 04541 (KR)
(72) Inventor: JUNG, Min Kyo, Seoul 04541 (KR); CHUNG, Dong Jin, Seoul 04541 (KR); JEON, Sung Gyu, Seoul 04541 (KR)
(74) Representative: Mooser, Sebastian Thomas
(86) International application number: PCT/KR2023/013615
(87) International publication number: WO 2024/058522

(57) **Abstract**

A tabbing device is a tabbing device including a stage for supporting solar cell and wire jig; a wire jig transfer device for transferring wire jig to the stage; a wire transfer device adjacent to the wire jig transfer device and transfers wire; and a cell-jig transfer device which positions the solar cell and the wire jig on the wire supported by the wire transfer device, wherein the cell-jig transfer device includes a body spindle; and multiple bodies which are rotated by the body spindle, support solar cell and wire jig on the stage, and position solar cell and wire jig, on wire on the wire transfer device, and the multiple bodies alternately perform an operation of supporting the solar cell and wire jig while rotating around the body spindle, and an operation of positioning solar cell and wire jig on wire.

## Description

### [Technical Field]

The present invention relates to a tabbing device and a tabbing method.

### [Background Art]

A solar cell, that is, a solar battery includes a substrate and a diode mounted on the substrate and formed by a p-n junction. When a solar cell is irradiated with sunlight, an exciton, which is an electron-hole pair, is generated, and as the exciton separates, the electron moves to an n layer and the hole moves to a p layer, and thus photovoltaic power is generated at a p-n junction. Tabbing is a process of forming a single solar cell module by arranging wires on a plurality of solar cells to electrically connect the plurality of solar cells.

Typically, a tabbing device joins the solar cell to the wire in a state in which the solar cell is placed on the wire. The solar cell is positioned on the wire while the wire is transferred in one direction by a wire transfer device to connect the solar cell and the wire. Additionally, in the process of connecting the solar cell and the wire, a wire jig is positioned on the wire to apply pressure to the wire to prevent the wire from coming off or deviating from a designated location. In this way, a cell-jig transfer device positions the solar cell and the wire jig on the wire.

However, conventional cell-jig transfer devices have to go through two steps of first picking up one of the solar cell and the wire jig, placing the one on the wire, and then returning to an original position to pick up and position the remaining one on the wire. Thus, there is a problem that the entire process is delayed because it takes a lot of time to position the solar cell and the wire jig on the wire.

Meanwhile, when such a transfer device is configured linearly, the transfer device that has picked up a solar cell and a jig has to position the solar cell and the jig on the wire and then return to an original state to pick up a solar cell and a jig. In other words, since the pickup and positioning operations have to be performed sequentially, there is a limit to increasing the speed of a solar cell manufacturing process.

Additionally, the tabbing device includes a device that supplies solar cells, a device that receives and aligns the solar cells, inspects the solar cells, and then cuts (scribes) the solar cells to a desired size, and a device that discharges defective solar cells. Conventional tabbing devices use SCARA robots that move along orthogonal axes to supply solar cells and perform the alignment and inspection processes and the cutting process. Thus, the overall size of the tabbing device increases, and since each of the processes is performed sequentially, the tabbing process takes a lot of time.

### [Disclosure]

### [Technical Problem]

A tabbing device and a tabbing method can simultaneously transfer solar cells and wire jigs, and furthermore, by configuring a plurality of transfer devices as a rotary type, the time and cost required for manufacturing solar cell modules can be reduced.

A tabbing device and a tabbing method can reduce the time required to transfer solar cells while reducing a size of the tabbing device by using a rotary index table.

### [Technical Solution]

A tabbing device includes a stage configured to support a solar cell and a wire jig, a wire jig transfer device configured to transfer the wire jig to the stage, a wire transfer device adjacent to the wire jig transfer device and configured to transfer a wire, and a cell-jig transfer device configured to position the solar cell and the wire jig on the wire supported by the wire transfer device, wherein the cell-jig transfer device includes a body spindle, and a plurality of bodies which are rotated by the body spindle, support the solar cell and the wire jig on the stage, and position the solar cell and the wire jig on the wire on the wire transfer device, and the plurality of bodies alternately perform an operation of supporting the solar cell and the wire jig while rotating around the body spindle, and an operation of positioning the solar cell and the wire jig on the wire.

Each of the plurality of bodies may support a solar cell and wire jig of a different set.

The cell-jig transfer device may position any one of the plurality of bodies on the stage and the other above the wire transfer device, and when one body supports the solar cell and the wire jig above the stage, the other body may simultaneously position the solar cell and the wire jig on the wire on the wire transfer device.

The plurality of bodies may include a first body and a second body which face each other with the body spindle as a center, the first body and the second body may support different sets of solar cells and wire jigs, and when the first body positions a solar cell and wire jig of one set on the wire, the second body may simultaneously support a solar cell and wire jig of another set positioned on the stage.

Each of the plurality of bodies may simultaneously support a solar cell and wire jig of one set, or may simultaneously position a solar cell and wire jig of one set on the wire.

The tabbing device may includes an index table including a table spindle and a plurality of table supports configured to rotate around the table spindle, a first solar cell transfer device configured to transfer the solar cell to the index table, and a solar cell supply device configured to transfer the solar cell from the first solar cell transfer device to the index table, the index table may include a solar cell alignment device, a solar cell inspection device, and a solar cell division device which are located to correspond to the plurality of table supports, respectively, and the index table may move the solar cell transferred from the first solar cell transfer device to the solar cell alignment device, the solar cell inspection device, and the solar cell division device, while rotating at a predetermined angle.

The first solar cell transfer device may transfer the solar cell to a table support corresponding to the solar cell alignment device among the plurality of table supports, and the index table may sequentially move the solar cell to the solar cell inspection device and the solar cell division device while rotating around the table spindle.

When the solar cell alignment device completes an alignment process, the index table may rotate to move the aligned solar cell to the solar cell inspection device, and the first solar cell transfer device may move the solar cell to a support corresponding to the solar cell alignment device.

The index table may support one or more solar cells simultaneously, and at least two of the solar cell alignment device, the solar cell inspection device, and the solar cell division device may operate simultaneously.

The plurality of table supports may include four table supports orthogonal to each other with the table spindle as the center, and the index table may rotate in 90 degree units.

The solar cell alignment device may check and correct a position of the solar cell when the transferred solar cell is positioned on the table support, the solar cell inspection device may inspect whether the position-corrected solar cell is defective, and the solar cell division device may divide the solar cell determined to be a good product by the solar cell inspection device into a predetermined size.

The index table may further include a solar cell discharge device located on a side opposite to the solar cell inspection device with the table spindle as the center, and configured to discharge the solar cell determined to be a defective product to the outside of the tabbing device, when the solar cell inspection device determines that the solar cell is a good product, the solar cell division device may divide the solar cell, and when the solar cell inspection device determines that the solar cell is a defective product, the solar cell division device may not divide the solar cell, and the solar cell discharge device may discharge the solar cell.

The solar cell alignment device and the solar cell division device may be located on opposite sides with the table spindle as the center.

The solar cell supply device may include a support shaft, a plurality of support frames configured to extend in different directions from the support shaft, and a plurality of holders respectively connected to the plurality of support frames to support the solar cells, and any one of the plurality of holders may overlap any one of the plurality of table supports of the index table.

The first solar cell transfer device may include two first solar cell transfer devices each corresponding to the solar cell supply device, and the plurality of support frames may include four support frames orthogonal to each other with the support shaft as the center and may support simultaneously two solar cells transferred from the first solar cell transfer device.

A tabbing method includes supporting a solar cell and wire jig of one set supported on a stage with any one body by a cell-jig transfer device including a plurality of bodies, positioning the supported solar cell and wire jig of one set on a wire located on a wire transfer device by rotating the cell-jig transfer device, and supporting a solar cell and wire jig of another set supported on the stage with another body of the plurality of bodies by the cell-jig transfer device, wherein the supporting of the solar cell and the wire jig and the positioning of the solar cell and wire jig on the wire are repeated.

The transferring of the solar cell and the wire jig and the positioning of the solar cell and the wire jig on the wire may be performed simultaneously.

The tabbing method may further include, before the supporting of the solar cell and wire jig of one set, delivering a solar cell from a first solar cell transfer device to an index table by a solar cell supply device, aligning the solar cell by a solar cell alignment device, inspecting the aligned solar cell to determine whether the solar cell is a good product or a defective product by a solar cell inspection device, dividing the solar cell determined to be a good product by a solar cell division device, and sequentially moving the solar cell to the solar cell alignment device, the solar cell inspection device, and the solar cell division device located to correspond to a plurality of table supports of the index table, while the index table is rotated at a predetermined angle, between the aligning of the solar cell, the inspecting of the solar cell, and the dividing of the solar cell.

At least two of the aligning of the solar cell, the inspecting of the solar cell, and the dividing of the solar cell may be performed simultaneously.

The tabbing method may further include discharging the solar cell to the outside by a solar cell discharge device of the index table, when the solar cell is determined to be a defective product in the inspecting of the solar cell.

### [Advantageous Effects]

In a tabbing device and tabbing method, a cell-jig transfer device is configured as a rotary type so that supporting and positioning operations of solar cells and wire jigs can be performed simultaneously. Therefore, the time required for a tabbing process can be reduced, the size of the tabbing device can be miniaturized, and the configuration can be simplified.

In a tabbing device and tabbing method, since the tabbing device includes a rotary index table, it is possible to perform a series of processes on solar cells more quickly, thereby shortening the time required for a tabbing process and reducing the size of the tabbing device.

### [Description of Drawings]

FIG. 1 schematically illustrates a tabbing device.
FIGS. 2 and 3 each illustrate a body of a cell-jig transfer device.
FIGS. 4 to 9 are plan views illustrating the operation of the cell-jig transfer device.
FIG. 10 illustrates the operation of the cell-jig transfer device.
FIG. 11 schematically illustrates the tabbing device.
FIG. 12 illustrates a solar cell supply device and an index table.
FIGS. 13 to 17 illustrate the operations of the solar cell transfer device, the solar cell supply device, and the index table.
FIGS. 18 and 19 illustrate the solar cell transfer device and the index table.

### [Best Mode]

A tabbing device includes a stage configured to support a solar cell and a wire jig, a wire jig transfer device configured to transfer the wire jig to the stage, a wire transfer device adjacent to the wire jig transfer device and configured to transfer a wire, and a cell-jig transfer device configured to position the solar cell and the wire jig on the wire supported by the wire transfer device, wherein the cell-jig transfer device includes a body spindle, and a plurality of bodies which are rotated by the body spindle, support the solar cell and the wire jig on the stage, and position the solar cell and the wire jig on the wire on the wire transfer device, and the plurality of bodies alternately perform an operation of supporting the solar cell and the wire jig while rotating around the body spindle and an operation of positioning the solar cell and the wire jig on the wire.

### [Modes of the Invention]

Hereinafter, the present disclosure will be described with reference to embodiments illustrated in the attached drawings. The described embodiments are not limited to the contents described in the present specification and may have different forms. Therefore, the embodiments are merely described below with reference to the drawings to explain aspects and features of the present invention.

The present disclosure includes various embodiments and modified examples, specific embodiments of which are illustrated in the drawings and described below. However, the present disclosure is not limited to the embodiments, and includes all modifications, equivalents, and substitutes included in the spirit and scope of the present invention.

When an element or layer is referred to as being "on" another element or layer, or "connected" or "coupled" to another element or layer, the element or layer can be directly on, connected or coupled to the other element or layer. Alternatively, one or more additional elements or layers may be present. When an element or layer is referred to as being "directly on," "directly connected to," or "directly coupled to" another element or layer, there may not be any other intermediate elements or layers therebetween. For example, when a first element is described as being "coupled" or "connected" to a second element, the first element may be directly coupled or connected to the second element, or the first element may be indirectly coupled or connected to the second element through one or more intermediate elements.

The dimensions of various elements, layers, etc. in the drawings may be exaggerated for clarity of illustration. Identical reference symbols may represent identical elements. As used herein, the term "and/or" includes any and all combinations of one or more of the associated listed items. Additionally, the use of "may" when embodiments of the present disclosure are described relates to "one or more embodiments of the present disclosure." Expressions such as "at least one" and "any one," when placed before a list of elements, may modify the entire list of elements but not individual elements of the list. For example, the expression "at least one of a, b, and c" could mean a only, b only, c only, both a and b, both a and c, both b and c, all of a, b, and c, or variations thereof. As used herein, the terms "use," "using," and "used" may be considered synonymous with the terms "utilize," "utilizing," and "utilized," respectively. The terms "substantially," "about," and similar terms, as used herein, are used as terms of approximation rather than degrees, and are intended to account for inherent variations in measured or calculated values that are recognized by one of ordinary skill in the art.

Although the terms first, second, third, etc. may be used herein to describe various elements, components, regions, layers, and/or sections, these elements, components, regions, layers, and/or sections are not limited to these terms. These terms are used to distinguish one element, component, region, layer, or section from another element, component, region, layer, or section. Accordingly, a first element, first component, first region, first layer or first section discussed below could be named a second element, second component, second region, second layer or second section without departing from the disclosure of the exemplary embodiments.

Spatially relative terms such as "below," "downward," "above," "upward," or the like may be used herein for convenience of description to describe the relationship of one element or feature with respect to another element(s) or function(s) depicted in the drawings. The spatially relative terms may include other orientations of a device in use or operation in addition to the orientations depicted in the drawings. For example, when a device in a drawing is turned over, an element described as being "below" or "under" another element or feature may instead be oriented "above" or "on" the other element or feature. Therefore, the term "below" may include both upward and downward directions. The device may be oriented in different directions (rotated 90 degrees or in different directions) and the spatially relative descriptors used herein should be interpreted accordingly.

The terms used in this specification are used to describe embodiments of the present invention and are not intended to limit the present invention. The singular forms used in this specification may also include plural forms unless the context clearly indicates otherwise. The terms "include," "have," and "comprise" when used herein specify specified features, integers, steps, operations, elements, and/or components, but do not exclude the presence or addition of one or more other features, integers, steps, operations, elements, components and/or groups thereof.

When the embodiment can be implemented as a process, certain process sequences may be performed differently from the order described. For example, two processes described sequentially may be performed concurrently or substantially concurrently, or may be performed in the reverse order of the order described.

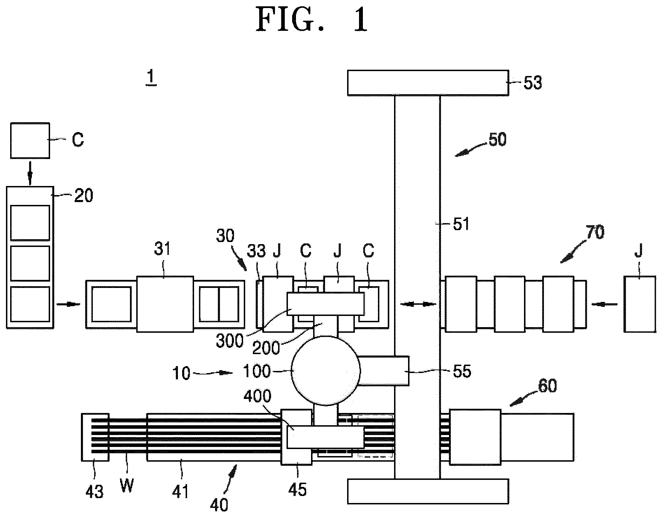

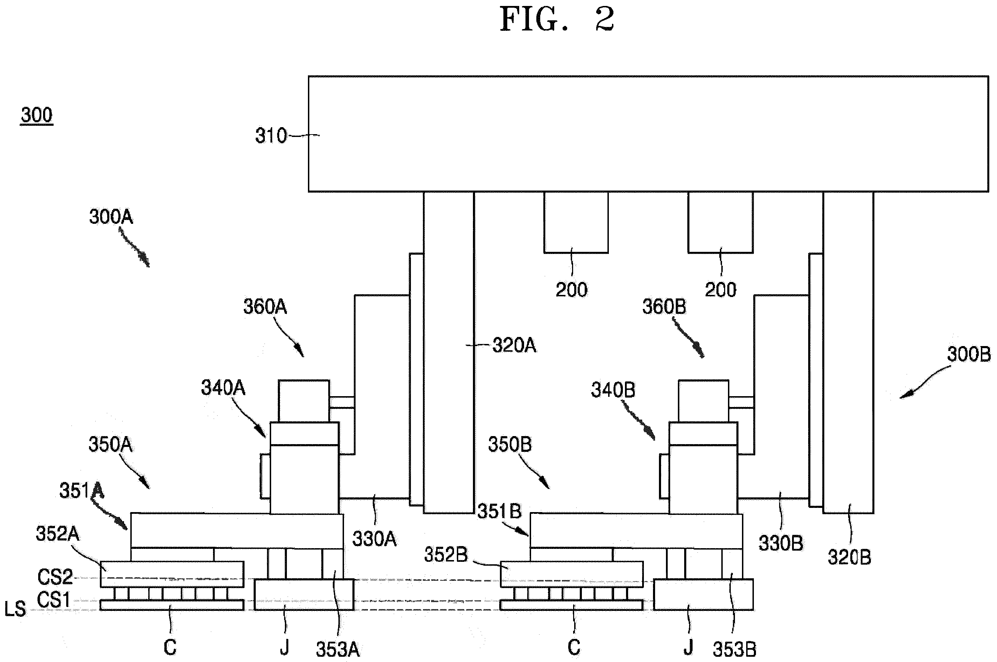

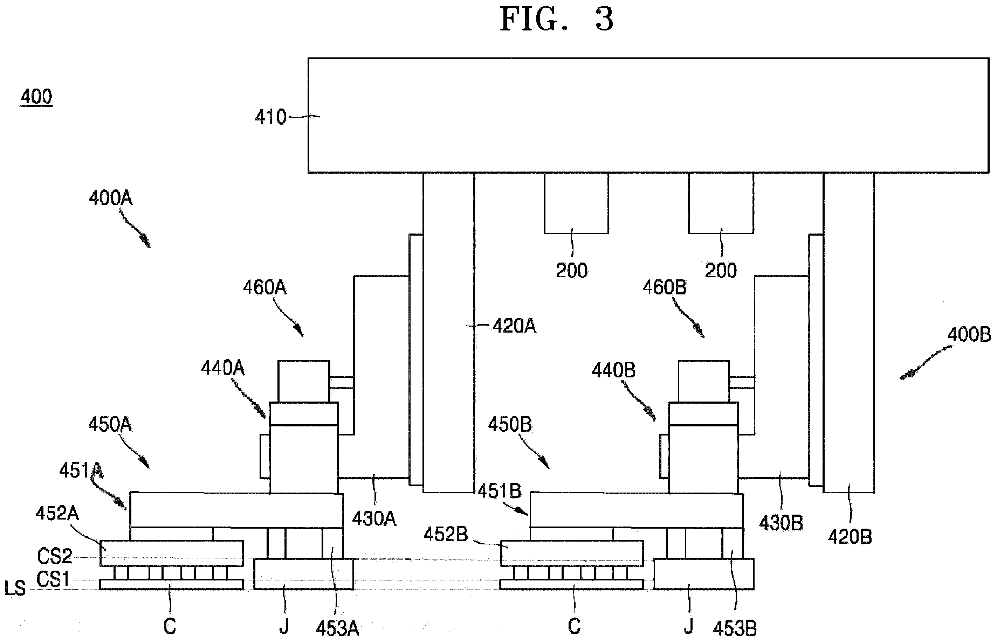

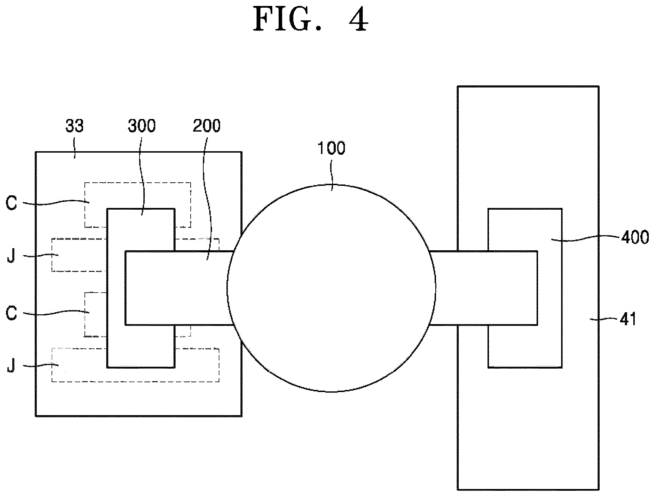

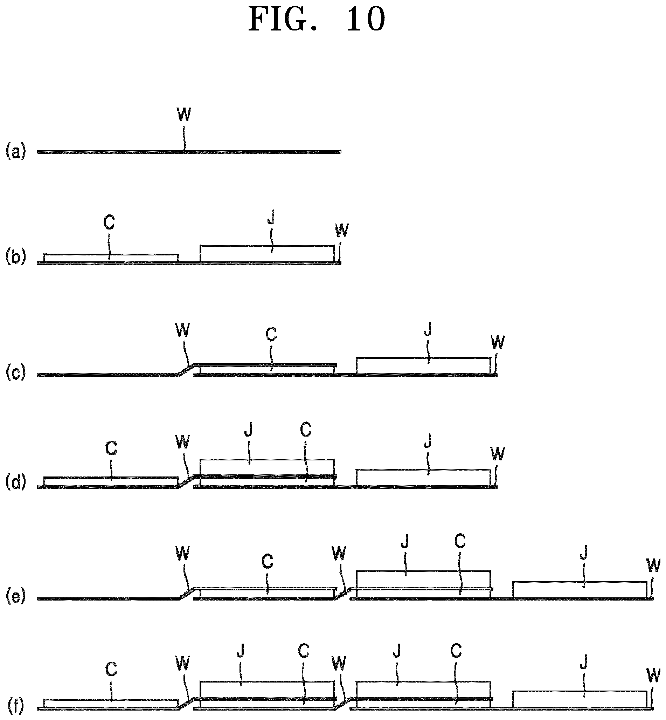

FIG. 1 schematically illustrates a tabbing device 1, FIGS. 2 and 3 each illustrate bodies 300 and 400 of a cell-jig transfer device 10, FIGS. 4 to 9 are plan views illustrating the operation of the cell-jig transfer device 10, and FIG. 10 illustrates the operation of the cell-jig transfer device 10.

The tabbing device 1 is a device for forming a solar cell module by connecting a solar cell C and a wire W. The solar cell C has a semiconductor junction region with a p-n junction surface, and when it is irradiated with energy greater than a certain magnitude, an electromotive force is generated, which can convert light energy into electrical energy. A semiconductor material included in the solar cell C is not particularly limited, and silicon (single crystal, polycrystalline, and amorphous), gallium arsenide, cadmium tellurium, cadmium sulfide, indium phosphide, copper indium gallium selenide (CIGS), an organic dye, or a mixture thereof may be used.

The wire W is a conductor for electrically connecting a plurality of solar cells C to each other, and connects a front surface and a back surface of adjacent solar cells C. For example, the wire W may be electrically connected to the solar cell C through a soldering process. Alternatively, the wire W may be electrically connected to the solar cell C via an electrically conductive adhesive (ECA).

A wire jig J fixes the wire W so that the wire W does not come off or deviate from a designated location when the solar cell C and the wire W are connected. For example, as shown in FIG. 1, in a state in which the wire W is positioned on a transfer member 41 of a wire transfer device 40, the wire jig J may be positioned above the transfer member 41 to press the wire W. Here, the transfer member 41 may include a conveyor, a shuttle, and the like. In addition, the wire jig J may be supported and transferred by the cell-jig transfer device 10.

As shown in FIG. 1, the tabbing device 1 may include the cell-jig transfer device 10, a first solar cell transfer device 20, a second solar cell transfer device 30, the wire transfer device 40, a transport device 50, a joining device 60, and a wire jig transfer device 70. For example, the tabbing device 1 may include a stage 33 that supports the solar cell C and the wire jig J, the wire jig transfer device 70 that transfers the wire jig J to the stage 33, the wire transfer device 40 adjacent to the wire jig transfer device 70 and transferring the wire W, and the cell-jig transfer device 10 that positions the solar cell C and the wire jig J on the wire supported by the wire transfer device 40.

The cell-jig transfer device 10 transfers the solar cell C and the wire jig J. For example, the cell-jig transfer device 10 may pick up the solar cell C and the wire jig J positioned on the stage 33 and then may move to the wire transfer device 40 to position the solar cell C and the wire jig J on the wire W. This will be described below.

The first solar cell transfer device 20 receives the solar cell C from the outside and transfers the solar cell C. For example, the first solar cell transfer device 20 provided with the transfer member 41 may transfer the solar cell C to the second solar cell transfer device 30. Here, the solar cell C may not be divided (scribed) into a predetermined size.

The second solar cell transfer device 30 may divide the solar cells C received from the first solar cell transfer device 20 into the required size and number. For example, the second solar cell transfer device 30 includes a scriber 31, and the scriber 31 may divide the solar cell C into a plurality of pieces using a laser or mechanical method. In addition, the second solar cell transfer device 30 may include the stage 33 that supports the solar cell C divided by the scriber 31. The stage 33 is movable in X-axis and Y-axis directions and may rotate in a θ direction, that is, around a Z-axis. The stage 33 may be displaced while supporting the solar cell C to correct a position of the solar cell C when the cell-jig transfer device 10 picks up the solar cell C.

A plurality of solar cells C and wire jigs J may be positioned on the stage 33. For example, the solar cell C divided by the scriber 31 may be positioned on the stage 33 by a transfer device (not shown). Additionally, the wire jig J transferred by the wire jig transfer device 70 may also be positioned above the stage 33 by a separate transfer device (not shown). Additionally, as shown in FIG. 1, the wire jigs J and the solar cells C may be alternately positioned on the stage 33. For example, two sets of wire jigs J and solar cells C may be positioned on the stage 33. The cell-jig transfer device 10 may support the wire jigs J and the solar cells C while positioned on the stage 33.

The wire transfer device 40 receives the wire W from the outside and moves the wire W. For example, the wire transfer device 40 may include the transfer member 41, a roller 43, and an aligner 45.

The transfer member 41 may have a flat upper surface so that a plurality of wires W can move while being spaced apart from each other. The roller 43 is connected to an end portion of the wire transfer device 40 so that the wires W are transferred while positioned on the upper surface of the transfer member 41. Although not shown in the drawing, rollers 43 may be connected to one side and the other side of the wire transfer device 40 so that the transfer member 41 is positioned therebetween. The aligner 45 primarily aligns the wire W before the solar cell C and the wire W come into contact with each other, that is, before the solar cell C is positioned on the wire W. For example, the aligner 45 may have a number of grooves or protrusions corresponding to the plurality of wires W so as to allow the wires W to move along a designated path.

The transport device 50 moves the solar cell C and the wire jig J with the wire W. The transport device 50 may include a first frame 51 and a second frame 53. The first frame 51 and the second frame 53 intersect each other, and the first frame 51 may move between a fixed pair of second frames 53. For example, as shown in FIG. 1, the first frame 51 and the second frame 53 may intersect in a direction perpendicular to each other when viewed from above.

The first frame 51 may be provided with the cell-jig transfer device 10. The cell-jig transfer device 10 may support (pick up) the solar cell C and the wire jig J while moving in a longitudinal direction of the first frame 51, for example, in a first direction in a state in which the cell-jig transfer device 10 is connected to the first frame 51, and may position the solar cell C and the wire jig J on the wire W.

Additionally, the transport device 50 may include a slider 55 that slidably connects the cell-jig transfer device 10 to the first frame 51. The slider 55 is movable in the longitudinal direction of the first frame 51 and may move the cell-jig transfer device 10 between the stage 33 and the wire transfer device 40.

The joining device 60 may join the solar cell C and the wire W that are in contact with each other. For example, the joining device 60 may be a soldering device that applies a solder to a connection portion of the solar cell C and the wire W and then heats the solder to join the solar cell C and the wire W. Alternatively, the joining device 60 may be a device that joins the solar cell C and the wire W by applying an electrically conductive adhesive to the connection portion of the solar cell C and the wire W.

The wire jig transfer device 70 receives the wire jig J from the outside and transfers the wire jig J. For example, the wire jig transfer device 70 including the transfer member 41 may transfer the wire jig J toward the stage 33 so that the cell-jig transfer device 10 can pick up the wire jig J. Additionally, a transfer device (not shown) may transfer the wire jig J positioned on the wire jig transfer device 70 to the stage 33.

The cell-jig transfer device 10 will be described again with reference to FIGS. 1 to 9.

The cell-jig transfer device 10 is connected to the transport device 50 and transfers the solar cell C and the wire jig J while moving in the first direction (for example, in the longitudinal direction of the transport device 50). For example, the cell-jig transfer device 10 may support the solar cell C and the wire jig J positioned on the stage 33 and then may move above the wire transfer device 40. Then, the cell-jig transfer device 10 may position the solar cell C and the wire jig J on the wire W and may perform a process of fixing the wire W and connecting the wire W and the solar cell C. Here, positioning the solar cell C and the wire jig J on the wire W may mean an action of seating the solar cell C and the wire jig J on the wire W so that the solar cell C and the wire jig J press the wire W from above.

The cell-jig transfer device 10 may simultaneously support the solar cell C and the wire jig J and also position the solar cell C and the wire jig J on the wire W at the same time. Additionally, the cell-jig transfer device 10 may support a plurality of solar cells C and a plurality of wire jigs J and position the solar cells C and the wire jigs J on the wire W.

The cell-jig transfer device 10 may be rotatable. The cell-jig transfer device 10 supports the solar cell C and the wire jig J on one side thereof and then rotates at a predetermined angle, for example, 180 degrees, to position the solar cell C and the wire jig J on the wire W. Then, the cell-jig transfer device 10 supports the solar cell C and the wire jig J on the opposite side thereof and then rotates again at a predetermined angle to position the solar cell C and the wire jig J on the wire W.

The cell-jig transfer device 10 may include a body spindle 100, a body support 200, and a plurality of bodies (for example, a first body 300 and a second body 400).

The body spindle 100 may rotate around an axis and is connected to the first frame 51 through the slider 55. For example, as shown in FIG. 1, the body spindle 100 may rotate clockwise or counterclockwise in a plane around an axis parallel to a Z axis. A shape of the body spindle 100 is not particularly limited and may have a cylindrical shape, for example.

The body support 200 is connected to one side of the body spindle 100 and supports each of the first body 300 and the second body 400. For example, the body support 200 is connected to a lower end of the body spindle 100 and may extend in one direction. The body support 200 may be made of one or more pipes, tubes, etc., and the plurality of bodies (for example, the first body 300 and the second body 400) may be connected to each end thereof.

Each of the plurality of bodies may support a solar cell C and wire jig J of a different set. For example, one (for example, the first body 300) of the plurality of bodies may support a solar cell C and wire jig J of a first set, and another body (for example, the second body 400) may support a solar cell C and wire jig J of a second set.

The cell-jig transfer device 10 may position one of the plurality of bodies above the stage 33 and may position the other body above the wire transfer device 40. In addition, in the cell-jig transfer device 10, when one body supports the solar cell C and the wire jig J on the stage 33, simultaneously, another body may position the solar cell C and the wire jig J on the wire W located on the wire transfer device 40.

Each of the plurality of bodies may simultaneously support a solar cell C and wire jig J of one set, or may simultaneously position a solar cell C and wire jig J of one set on the wire W.

The first body 300 may support the solar cell C and the wire jig J positioned on the stage 33 and may position the solar cell C and the wire jig J on the wire W supported on the wire transfer device 40. The first body 300 may be connected to one end (for example, an upper end portion in FIG. 1) of the body support 200.

The first body 300 may support one or more solar cells C and wire jigs J. For example, in a state in which the first body 300 supports two solar cells C and two wire jigs **J,** the first body 300 may simultaneously or sequentially position the two solar cells C and the two wire jigs J on the wire W.

The first body 300 may include a support frame 310, a first picker 300A, and a second picker 300B.

The support frame 310 connects the first body 300 to the body support 200. For example, as shown in FIG. 2, the support frame 310 has a plate or bar shape that extends in one direction, and a lower surface thereof may be supported by the body support 200. Additionally, the first picker 300A and the second picker 300B may be connected to one side and the other side of the support frame 310, respectively. When the body spindle 100 rotates, the support frame 310 connected to the body support 200 rotates, and the first picker 300A and the second picker 300B connected to the support frame 310 may rotate together.

The first picker 300A may support the solar cell C and the wire jig J. The first picker 300A is connected to one side of the support frame 310, for example, a front side of the lower surface in FIG. 2, and may support the solar cell C and the wire jig J while moving in various directions. For example, the first picker 300A may move in a height direction (for example, a height direction of the first body 300) and a plane direction perpendicular thereto (for example, a width direction or longitudinal direction of the first body 300), may support the solar cell C and the wire jig J positioned on the stage 33, and may position the solar cell C and the wire jig J on the wire W.

The first picker 300A may include a connection part 320A, a first movement part 330A, a second movement part 340A, a support part 350A, and a stationary part 360A.

The connection part 320A connects the first picker 300A to the support frame 310. For example, the connection part 320A extends downward from one side of a lower surface of the support frame 310 and may have a plate shape.

The first movement part 330A is slidably connected to the connection part 320A and may move the support part 350A. For example, in the first movement part 330A, the other side may be connected to the second movement part 340A so that a portion thereof may be raised and lowered along one surface of the connection part 320A that extends in a height direction (for example, in an up-down direction in FIG. 2). As the first movement part 330A moves, the second movement part 340A and the support part 350A connected thereto may move in the height direction.

The second movement part 340A may be connected to move integrally with the first movement part 330A. For example, as shown in FIG. 2, the second movement part 340A is located on a protruding portion of the first movement part 330A and may be raised and lowered simultaneously as the first movement part 330A is raised and lowered. In addition, the second movement part 340A may move in a different direction independently from the first movement part 330A. For example, the second movement part 340A may move in left and right directions of FIG. 2. The support part 350A may be located on one side of the second movement part 340A.

The support part 350A may be connected to move integrally with the second movement part 340A. For example, the support part 350A may be located on a lower surface of the second movement part 340A. The support part 350A may include a support plate 351A, a solar cell support part 352A, and a wire jig support part 353A.

The support plate 351A is located on the lower surface of the second movement part 340A, and the solar cell support part 352A and the wire jig support part 353A are located on one side and the other side of a lower surface of the support plate 351A, respectively. When the first body 300 reaches a designated position, the first movement part 330A and the second movement part 340A move to adjust a position of the support part 350A. When the positioning is completed, the first movement part 330A is lowered so that the solar cell support part 352A supports the solar cell C positioned on the stage 33. Additionally, the second movement part 340A is lowered and supports the wire jig J positioned on the stage 33. Then, the second movement part 340A is raised again, and the body spindle 100 rotates so that the first body 300 moves to the wire W positioned on the wire transfer device 40 and then positions the solar cell C and the wire jig J on the wire W.

The solar cell support part 352A and the wire jig support part 353A may support the solar cell C and the wire jig J, respectively, by suction. For example, each of the solar cell support part 352A and the wire jig support part 353A may have a plurality of suction holes connected to a negative pressure source (not shown).

Alternatively, the solar cell support part 352A and the wire jig support part 353A may be used as an electromagnetic chuck to support the solar cell C and the wire jig J using an electromagnet.

The heights of surfaces at which the solar cell support part 352A and the wire jig support part 353A respectively come into contact with the wire jig J and the solar cell C may be different from each other. For example, as shown in FIG. 2, a first contact surface CS1 at which the solar cell support part 352A comes into contact with the solar cell C may be positioned lower than a second contact surface CS2 at which the wire jig support part 353A comes into contact with the wire jig J. That is, the first contact surface CS1 and the second contact surface CS2 may be located at different heights.

The solar cell C and the wire jig J may be positioned on the same plane while being supported by the solar cell support part 352A and the wire jig support part 353A. For example, as shown in FIG. 2, when the solar cell support part 352A and the wire jig support part 353A pick up the solar cell C and the wire jig J, respectively, lower surfaces of the solar cell C and the wire jig J may be positioned on the same plane LS.

The first body 300 may simultaneously support the solar cell C and the wire jig J in one operation of lowering the solar cell support part 352A and the wire jig support part 353A onto the solar cell C and the wire jig J. In addition, the first body 300 may position the solar cell C and the wire jig J on the wire W in one operation of lowering the solar cell support part 352A and the wire jig support part 353A onto the wire W.

The second picker 300B may support the solar cell C and the wire jig J, like the first picker 300A. The second picker 300B is connected to the other side of the support frame 310, for example, a rear side of the lower surface in FIG. 2, and may support the solar cell C and the wire jig J while moving in multiple directions. That is, the first picker 300A may be positioned in front of the body support 200, and the second picker 300B may be positioned behind. For example, the second picker 300B may move in a height direction and in a plane direction perpendicular thereto, may support the solar cell C and the wire jig J positioned on the stage 33, and may position the solar cell C and the wire jig J on the wire W.

The second picker 300B may include a connection part 320B, a first movement part 330B, a second movement part 340B, a support part 350B, and a stationary part 360B. Additionally, the support part 350B may include a support plate 351B, a solar cell support part 352B, and a wire jig support part 353B. These configurations are identical to those of the first picker 300A, and a detailed description thereof will be omitted.

When the first picker 300A supports the solar cell C and wire jig J of one set, a new solar cell C divided by the scriber 31 is positioned on the stage 33 by a transfer device (not shown), and a new wire jig J is transferred by a transfer device (not shown) from the wire jig transfer device 70 and is positioned on the stage 33. Then, the second picker 300B may be lowered to support the solar cell C and wire jig J of the new set. Here, the cell-jig transfer device 10 does not move in parallel, and two sets of wire jigs J and solar cells C may be positioned on the stage 33 by the transfer device to correspond to the second picker 300B.

On the stage 33, two sets of wire jigs J and solar cells C are positioned, and the first picker 300A and the second picker 300B may be lowered simultaneously to support the two sets of wire jigs J and solar cells C.

The second body 400 may support the solar cell C and the wire jig J positioned on the stage 33 and may position the solar cell C and the wire jig J on the wire W positioned on the wire transfer device 40. The second body 400 may be connected to the other end (for example, a lower end portion of FIG. 1) of the body support 200. The second body 400 may face the first body 300 with the body spindle 100 as the center. Additionally, the second body 400 may support a solar cell C and wire jig J of a different set from that in the first body 300.

The second body 400 may support one or more solar cells C and wire jigs J. For example, in a state in which the second body 400 supports two solar cells C and two wire jigs **J,** the second body 400 may simultaneously or sequentially position the two solar cells C and the two wire jigs J on the wire W.

The second body 400 may include a support frame 410, a first picker 400A, and a second picker 400B. The configuration of the second body 400 is substantially the same as the configuration of the first body 300 described above, and a detailed description thereof will be omitted.

The first body 300 and the second body 400 may be spaced apart from the center of the body spindle 100 by the same distance.

The first body 300 and the second body 400 may alternately support and position the solar cells C and the wire jigs J while rotating around the body spindle 100. For example, when the first body 300 is lowered toward the stage 33 to support the solar cell C and the wire jig J, the second body 400 may position the supporting solar cell C and wire jig J on the wire W positioned on the transfer member 41 of the wire transfer device 40.

In particular, the first body 300 and the second body 400 may have a preset interval. For example, a distance in one direction between the first body 300 and the second body 400 may correspond to a distance in one direction between the stage 33 and the wire transfer device 40. In detail, a distance between the centers of the first body 300 and the second body 400 in one direction may be equal to a distance between the center of the transfer member 41 of the wire transfer device 40 and the center of the stage 33. Here, the one direction is a distance in an up-down direction in FIG. 1, which may be an extension direction of the first frame 51.

The operations of supporting the solar cell C and the wire jig J and positioning the solar cell C and the wire jig J on the wire W by each of the first body 300 and the second body 400 may be performed simultaneously. For example, when the first body 300 supporting two sets of solar cells C and wire jigs J positions the solar cell C and wire jig J of one set on the wire W, the second body 400 may simultaneously support the other solar cell C and wire jig J.

In a state in which the cell-jig transfer device 10 is positioned by the transport device 50, one of the first body 300 and the second body 400 may be positioned above the stage 33 to correspond thereto, and the other may be positioned above the wire transfer device 40 to correspond thereto.

For example, at the beginning of a tabbing process, the transport device 50 positions the cell-jig transfer device 10 between the stage 33 and the wire transfer device 40. Here, the first body 300 of the cell-jig transfer device 10 may be positioned to correspond to the solar cell C and the wire jig J positioned on the stage 33. Additionally, the second body 400 may be positioned to correspond to the wire W positioned on the transfer member 41 of the wire transfer device 40. The cell-jig transfer device 10 may support and position the solar cell C and the wire jig J only by the rotation of the body spindle 100 and raising and lowering motions of the first body 300 and the second body 400 without any additional movement.

Next, the operation and tabbing method of the cell-jig transfer device 10 will be described with reference to FIGS. 1 to 10.

The tabbing method includes an operation of supporting the solar cell C and wire jig J of one set supported on the stage 33 with any one body by the cell-jig transfer device 10 including a plurality of bodies, an operation of rotating the cell-jig transfer device 10 to position the supported solar cell C and wire jig J of one set on the wire W located on the wire transfer device 40, and an operation of supporting a solar cell C and wire jig J of another set supported on the stage 33 with another body of the plurality of bodies by the cell-jig transfer device 10, and the operations of supporting the solar cell C and the wire jig J and positioning the solar cell C and the wire jig J on the wire W may be repeated.

The operation of transferring the solar cell C and the wire jig J and the operation of positioning the solar cell C and the wire jig J on the wire W may be performed simultaneously.

First, as shown in FIG. 4, the cell-jig transfer device 10 is positioned at a preset position. For example, the cell-jig transfer device 10 may be positioned between the stage 33 and the wire transfer device 40.

For example, the first body 300 of the cell-jig transfer device 10 may be positioned to correspond to the solar cell C and the wire jig J located on the stage 33. In addition, the second body 400 may be positioned to correspond to the transfer member 41.

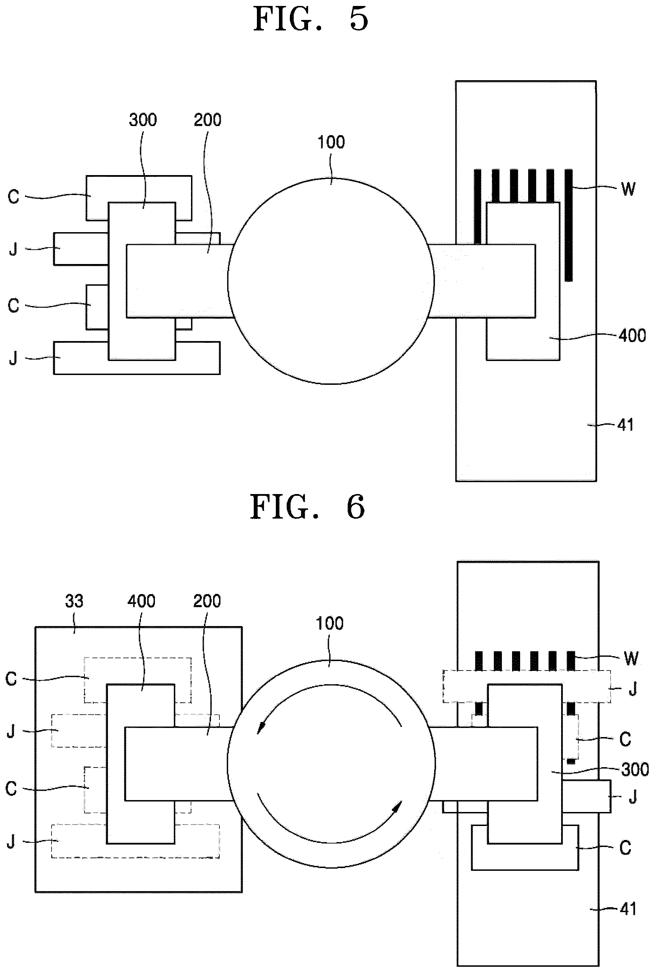

Next, the first body 300 supports the solar cell C and the wire jig J. As shown in FIG. 5, the first body 300 may be lowered to support the solar cell C and the wire jig J. Here, the first body 300 may support two sets of solar cells C and wire jigs J as described above. That is, the first picker 300A of the first body 300 may be lowered to support the solar cell C and wire jig J of one set, and the second picker 300B may be lowered to support the solar cell C and wire jig J of one set.

Further, as shown in FIG. 10A, the wire W may be introduced. For example, a wire guide (not shown) may pull the wire W and may position the wire W on the transfer member 41. A point in time at which the wire W is positioned on the transfer member 41 and a point in time at which the first body 300 supports the wire jig J and the solar cell C may be the same or different.

Next, the body spindle 100 rotates 180 degrees to position the first body 300 above the wire W and to position the second body 400 above the solar cell C and the wire jig J. As shown in FIG. 6, the body spindle 100 may rotate 180 degrees, and two sets of solar cells C and wire jigs J supported by the first body 300 are positioned on the wire W. In addition, the second body 400 is positioned above the solar cell C and the wire jig J positioned on the stage 33.

Next, the first body 300 is lowered to position the solar cell C and wire jig J on the wire W. As shown in FIGS. 6 and 10B, the first body 300 may position the supported solar cell C and wire jig J on the wire W.

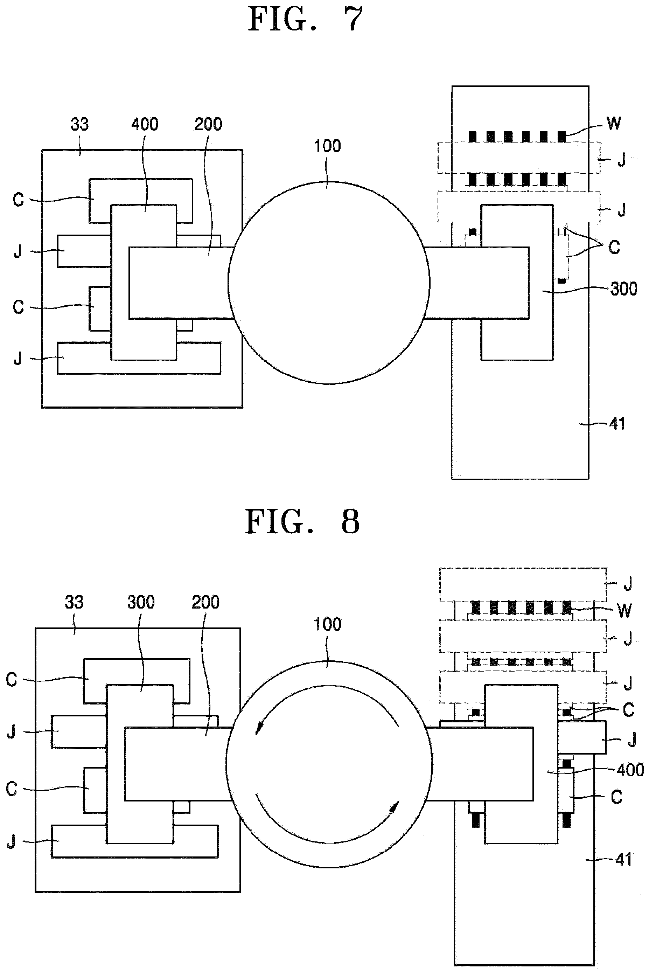

Next, as the transfer member 41 and/or cell-jig transfer device 10 moves, the positioned wire jig J, solar cell C, and wire W are moved, and a new wire W is positioned on the solar cell C positioned by the wire guide. For example, as shown in FIGS. 7 and 10C, the transfer member 41 may be moved or the cell-jig transfer device 10 may be moved along the second frame 53 to correspond to the wire jig J and the solar cell C that are still supported by the first body 300. Then, the wire W is positioned on the solar cell C at which the wire guide is positioned.

Next, as shown in FIG. 10D, the first body 300 positions the wire jig J on the positioned solar cell C and wire W, and positions the solar cell C on the wire W.

The second body 400 may support another solar cell C and wire jig J when the first body 300 positions the solar cell C and the wire jig J on the wire W. For example, as shown in FIG. 7, the second body 400 may support the solar cell C and the wire jig J when the first body 300 positions a solar cell C and wire jig J of a second set on the wire W. In another embodiment, the second body 400 may support the solar cell C and the wire jig J when the first body 300 positions a solar cell C and wire jig J of a first set on the wire W.

When the first body 300 positions two sets of solar cells C and wire jigs J on the wire W and the second body 400 supports another two sets of solar cells C and wire jigs J, the body spindle 100 rotates 180 degrees again. As shown in FIG. 8, the two sets of solar cells C and wire jigs J supported by the second body 400 are positioned on the wire W, and the first body 300 is positioned to correspond to the solar cell C and the wire jig J positioned on the stage 33. Additionally, as shown in FIG. 10E, the transfer member 41 and/or the cell-jig transfer device 10 move so that the positioned wire jig J, solar cell C, and wire W move, and a new wire W is positioned on the positioned solar cell C by the wire guide. Then, as shown in FIGS. 8 and 10F, the second body 400 is lowered to position the solar cell C and wire jig J of one set on the wire W.

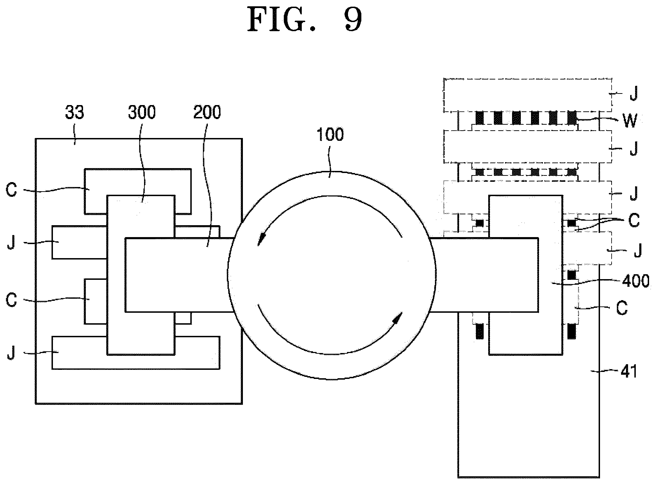

Next, as shown in FIG. 9, the second body 400 is lowered to position a solar cell C and wire jig J of the remaining set on the wire W.

By repeating this process, the cell-jig transfer device 10 may position the solar cells C and the wire jigs J on the wire W.

Alternatively, for example, referring to FIG. 4, the first body 300 of the cell-jig transfer device 10 may be positioned to correspond to the solar cell C and the wire jig J positioned on the stage 33. Additionally, the second body 400 may be positioned to correspond to the transfer member 41.

Next, the first body 300 supports the solar cell C and the wire jig J. For example, the first body 300 may be lowered to support the solar cell C and the wire jig J. Here, the first body 300 may support two solar cells C and one wire jig J, unlike what was described above. That is, the first picker 300A of the first body 300 may be lowered to support one solar cell C, and the second picker 300B may be lowered to support the solar cell C and wire jig J of one set.

Next, the body spindle 100 may rotate 180 degrees, the first picker 300A may be lowered, and the solar cell C (a first solar cell) supported by the first picker 300A may be positioned on the transfer member 41. Then, the wire W may be introduced onto the solar cell C (the first solar cell) positioned on the transfer member 41. For example, the wire guide (not shown) may pull the wire W to position one end of the wire W on the first solar cell.

Then, the second picker 300B may move. For example, the second picker 300B may move so that the supported jig J (a second jig) is positioned at a position at which it overlaps the first solar cell in a vertical direction. Then, the second picker 300B may be lowered again, and the second picker 300B may position the supported second jig on the wire W corresponding to the first solar cell and the solar cell C (a second solar cell) supported by the second picker 300B may be positioned on the other end of the wire W.

In addition, the second body 400 may support another two sets of solar cells C and wire jigs J positioned on the stage 33 when the second picker 300B is lowered to position the solar cell C (the second solar cell) and the jig J (the second jig) on the wire W.

Then, when the first body 300 positions two sets of solar cells C and one wire jig J on the wire W, and the second body 400 supports the other two sets of solar cells C and the wire jig J, the body spindle 100 rotates 180 degrees again, and the solar cells C and the wire jigs J may be positioned sequentially as shown in FIGS. 4 to 10 described above.

Therefore, the tabbing device 1 may position one end of the wire W on an upper surface of the first solar cell and may position the other end thereof on a lower surface of the second solar cell, and thus the two solar cells may be connected in series.

Next, a method of transferring the solar cell C and the wire jig J onto the wire W using the cell-jig transfer device 10 is described. The cell-jig transfer method may use the cell-jig transfer device 10 and tabbing device 1 described above.

The cell-jig transfer method may include an operation in which the cell-jig transfer device 10 moves between the stage 33 and the wire transfer device 40, an operation in which the cell-jig transfer device 10 supports the solar cell C and the wire jig J positioned on the stage 33 using the first body 300, an operation in which the cell-jig transfer device 10 rotates 180 degrees to position the solar cell C and the wire jig J supported by the first body 300 on the wire W positioned on the wire transfer device 40, and an operation in which the cell-jig transfer device 10 supports the solar cell C and the wire jig J positioned on the stage 33 using the second body 400, which is different from the first body 300.

First, the cell-jig transfer device 10 is positioned between the stage 33 and the wire transfer device 40. Once the positioning is completed, the first body 300 may be positioned to correspond to the solar cell C and the wire jig J positioned on the stage 33. Additionally, the second body 400 may be positioned to correspond to the wire W positioned on the transfer member 41 of the wire transfer device 40. In addition, even when the positions of the first body 300 and the second body 400 are reversed as the cell-jig transfer device 10 rotates, the second body 400 may be positioned to correspond to the solar cell C and the wire jig J, and the first body 300 may be positioned to correspond to the wire W.

Next, the cell-jig transfer device 10 supports the solar cell C and the wire jig J positioned on the stage 33 using the first body 300. As described above, since the first body 300 is positioned to correspond to the solar cell C and the wire jig J, the first body 300 may support the solar cell C and the wire jig J only by the lowering motion.

Here, the first body 300 may support two different sets of solar cells C and wire jigs J. For example, the first body 300 may support the solar cell C and wire jig J of one set simultaneously using the solar cell support part 352A and wire jig support part 353A provided in the first picker 300A. Additionally, when the support operation of the first picker 300A is completed, the first body 300 may simultaneously support the solar cell C and wire jig J of another set using the solar cell support part 352B and wire jig support part 353B provided in the second picker 300B. Alternatively, the first picker 300A and the second picker 300B may be lowered simultaneously to support the two sets of solar cells C and wire jigs J simultaneously.

Next, the cell-jig transfer device 10 rotates around the body spindle 100 to position the solar cell C and the wire jig J supported by the first body 300 above the wire W positioned on the wire transfer device 40. For example, the cell-jig transfer device 10 may rotate 180 degrees around the body spindle 100 so that the positions of the first body 300 and the second body 400 are reversed. As described above, since the first body 300 is positioned to correspond to the wire W, the first body 300 may position the solar cell C and the wire jig J on the wire W only by the lowering motion.

Additionally, the cell-jig transfer device 10 supports the solar cell C and the wire jig J positioned on the stage 33 using the second body 400. As described above, since the second body 400 is positioned to correspond to the solar cell C and the wire jig J, the second body 400 may support the solar cell C and the wire jig J only by the lowering motion.

Here, the second body 400 may support two different sets of solar cells C and wire jigs J. For example, the second body 400 may simultaneously support the solar cell C and wire jig J of one set using the solar cell support 452A and wire jig support 453A provided in the first picker 400A. Additionally, when the support operation of the first picker 400A is completed, the second body 400 may simultaneously support the solar cell C and wire jig J of another set using the solar cell support part 452B and wire jig support part 453B provided in the second picker 400B. Alternatively, the first picker 400A and the second picker 400B may be lowered simultaneously to support the two sets of solar cells C and wire jigs J simultaneously.

Additionally, the second body 400 may support another solar cell C and wire jig J when the first body 300 positions the solar cell C and the wire jig J on the wire W. For example, when one of two sets of solar cells C and wire jigs J supported by the first body 300 is first positioned on the wire W, the second body 400 may support a new solar cell C and wire jig J. Alternatively, when one set of the two sets of solar cells C and wire jigs J supported by the first body 300 are positioned on the wire W, and the solar cell C and wire jig J of the remaining set are positioned on the wire W, the second body 400 may support a new solar cell C and wire jig J.

In this way, when the first body 300 supports the solar cell C and the wire jig J, the cell-jig transfer device 10 may rotate 180 degrees to position the first body 300 above the wire W so that the solar cell C and the wire jig J are positioned on the wire W. Additionally, the cell-jig transfer device 10 may enable the second body 400 to support a new solar cell C and wire jig J.

Additionally, the cell-jig transfer device 10 may again rotate around the body spindle 100 to position the second body 400 supporting the solar cell C and the wire jig J above the wire W, and may position the empty first body 300 above the solar cell C and the wire jig J.

In this way, the cell-jig transfer device 10 may alternately repeat the operation of supporting the solar cell C and the wire jig J and the operation of positioning the solar cell C and the wire jig J on the wire W by changing the positions of the first body 300 and the second body 400 while rotating.

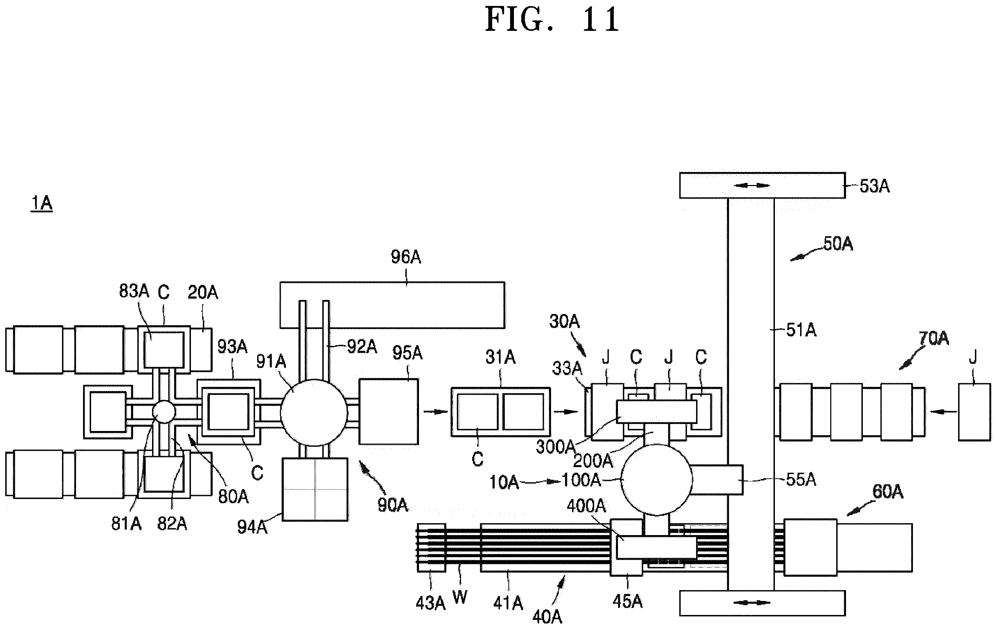

A tabbing device 1A is described with reference to FIGS. 11 to 17.

The tabbing device 1A may include a cell-jig transfer device 10A, a first solar cell transfer device 20A, a second solar cell transfer device 30A, a wire transfer device 40A, a transport device 50A, a joining device 60A, and a wire jig transfer device 70A. The tabbing device 1A may further include a solar cell supply device 80A and an index table 90A. For example, the tabbing device 1A may include the index table 90A including a table table spindle 91A and a plurality of table table supports 92A that are rotatable around the table table spindle 91A, the first solar cell transfer device 20A that transfers a solar cell C to the index table 90A, and the solar cell supply device 80A that transfers the solar cell C from the first solar cell transfer device 20A to the index table 90A, the index table 90A includes a solar cell alignment device 93A, a solar cell inspection device 94A, and a solar cell division device 95A that are positioned to correspond to the plurality of table table supports 92A, respectively, and the index table 90A may move the solar cell C transferred from the first solar cell transfer device 20A to the solar cell alignment device 93A, the solar cell inspection device 94A, and the solar cell division device 95A while rotating at a predetermined angle.

The cell-jig transfer device 10A may include a body spindle 100A, a body support 200A, and a plurality of bodies (for example, a first body 300A and a second body 400A). The configuration of the cell-jig transfer device 10A is the same as that of the cell-jig transfer device 10 described above, the same components are indicated in the drawing by adding "A" to the reference numerals, and a detailed description thereof will be omitted.

The first solar cell transfer device 20A is located on one side of the tabbing device 1 and transfers the solar cell C to the solar cell supply device 80A. For example, as shown in FIG. 11, the first solar cell transfer device 20A may be positioned to correspond to one or more of a plurality of holders 83A of the solar cell supply device 80A. The first solar cell transfer device 20A may be a conveyor that receives the solar cell C before it is divided from an external source such as a magazine and transfers the solar cell C to the solar cell supply device 80A.

The first solar cell transfer device 20A may include a plurality of first solar cell transfer devices 20A. For example, the first solar cell transfer device 20A may include two first solar cell transfer devices 20A corresponding to the solar cell supply device 80A. As shown in FIG. 11, the two first solar cell transfer devices 20A may be located on one side and the other side of the solar cell supply device 80A, respectively. The first solar cell transfer device 20A may transfer the solar cell C to the table table support 92A corresponding to the solar cell alignment device 93A among the plurality of table table supports 92A.

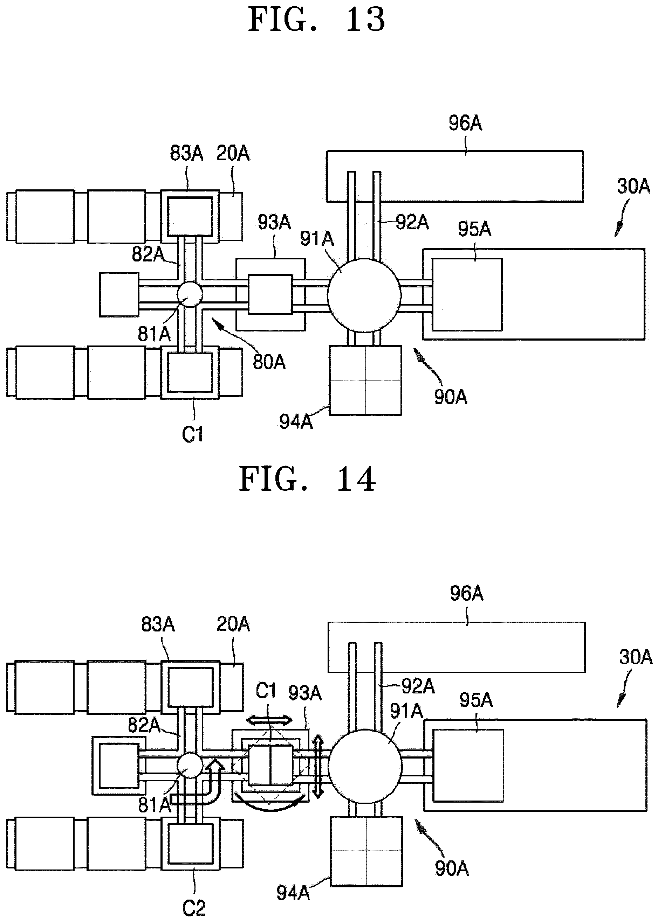

The second solar cell transfer device 30A receives the solar cell C from the index table 90A and transfers the solar cell C to the transport device 50A. For example, as shown in FIGS. 11 and 14, the second solar cell transfer device 30A is positioned to correspond to the solar cell division device 95A of the index table 90A and may support and transfer the solar cells C divided by the solar cell division device 95A.

The second solar cell transfer device 30A may include a transfer conveyor 31A and a stage 33A. The transfer conveyor 31A may transfer the divided solar cells C to the stage 33A, and the stage 33A may support the transferred solar cells C and may correct positions thereof. In this state, the cell-jig transfer device 10A of the transport device 50A may support the solar cell C supported on the stage 33A and the wire jig J supported by the wire jig transfer device 70 and then may move to the wire transfer device 40.

The wire transfer device 40A may include a transfer member 41A, a roller 43A, and an aligner 45A. The configuration of the wire transfer device 40A is the same as that of the wire transfer device 40 described above, the same components are indicated in the drawing by adding "A" to the reference numerals, and a detailed description thereof will be omitted.

The transport device 50A may include a first frame 51A, a second frame 53A, and a slider 55A. The configuration of the transport device 50A is the same as that of the transport device 50 described above, the same components are indicated in the drawing by adding "A" to the reference numerals, and a detailed description thereof will be omitted.

The configuration of the joining device 60A is the same as that of the joining device 60 described above, the same components are indicated in the drawing by adding "A" to the reference numerals, and a detailed description thereof will be omitted.

The configuration of the wire jig transfer device 70A is the same as that of the wire jig transfer device 70 described above, the same components are indicated in the drawing by adding "A" to the reference numerals, and a detailed description thereof will be omitted.

The solar cell supply device 80A transfers the solar cell C received from the first solar cell transfer device 20A to the index table 90A. The solar cell supply device 80A may include a support shaft 81A, a support frame 82A, and a holder 83A. The solar cell supply device 80A may include the support shaft 81A, a plurality of support frames 82A that extend in different directions from the support shaft 81A, and a plurality of holders 83A respectively connected to the plurality of support frames 82A to support the solar cells C, and any one of the plurality of holders 83A may overlap any one of the plurality of table supports 92A of the index table 90A.

The support shaft 81A transfers the solar cell C supported by the holder 83A to the index table 90A while rotating clockwise or counterclockwise around the Z-axis, for example. A plurality of support frames 82A are disposed around the support shaft 81A, and the holder 83A may be positioned at each end portion thereof. For example, four support frames 82A may be positioned in up, down, left, and right directions around the support shaft 81A. Additionally, the support shaft 81A may be raised and lowered in the height direction to transfer the solar cell C to the index table 90A. The plurality of support frames 82A may include four support frames 82A orthogonal to each other with the support shaft 81A as the center, and may simultaneously support two solar cells C that are transferred from the first solar cell transfer device 20A.

The holder 83A is located at an end portion of the support frame 82A and supports the solar cell C transferred from the first solar cell transfer device 20A. For example, as shown in FIG. 11, the holder 83A may be positioned on each of the four support frames 82A. In addition, as shown in FIG. 11, each of the holders 83A positioned above and below the support shaft 81A among the plurality of holders 83A may be positioned to correspond to two first solar cell transfer devices 20A. In addition, among the plurality of holders 83A, the holder 83A located on the right side with respect to the support shaft 81A may overlap the table support 92A located on the left side among the plurality of table supports 92A of the index table 90A. Thus, as the support shaft 81A rotates, the solar cell C supported by the holder 83A is transferred to the table support 92A.

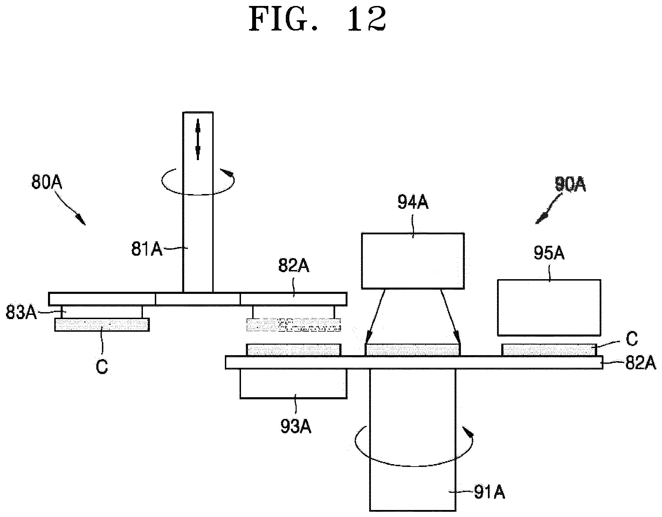

The holder 83A may support the solar cell C by suction. For example, as shown in FIG. 12, the holder 83A is located below the support frame 82A and may support the upper surface of the solar cell C by suction through suction holes or the like. In this state, the support shaft 81A is lowered to position the solar cell C on the table support 92A. Alternatively, the holder 83A may support the solar cell C through a mechanical clamping unit.

The index table 90A is located on one side of the tabbing device 1A and receives the solar cells C from the first solar cell transfer device 20A and the solar cell supply device 80A. Additionally, the index table 90A performs a process of inspecting and processing the received solar cell C. For example, as shown in FIG. 11, the index table 90A may be located between the solar cell supply device 80A and the second solar cell transfer device 30A.

The index table 90A may include a table spindle 91A, a table support 92A, a solar cell alignment device 93A, a solar cell inspection device 94A, a solar cell division device 95A, and a solar cell discharge device 96A. The index table 90A may sequentially move the solar cell C to the solar cell inspection device 94A and the solar cell division device 95A while rotating around the table table spindle 91A. When the solar cell alignment device 93A completes the alignment process, the index table 90A rotates to move the aligned solar cell C to the solar cell inspection device 94A, and the first solar cell transfer device 20A may move the solar cell C to the table support 92A corresponding to the solar cell alignment device 93A. The index table 90A supports one or more solar cells C simultaneously, and at least two of the solar cell alignment device 93A, the solar cell inspection device 94A, and the solar cell division device 95A may simultaneously operate.

The table spindle 91A is located at the center of the index table 90A and may rotate around its axis. For example, as shown in FIGS. 11 and 12, the table spindle 91A may have a cylindrical shape and may have a rotation axis extending in the height direction. The table spindle 91A may move the solar cell C to a subsequent process while rotating clockwise or counterclockwise around the rotation axis.

The table support 92A may be connected to the table spindle 91A and may rotate integrally with the table spindle 91A. For example, as shown in FIG. 11, a plurality of table supports 92A may be located on an upper end of the table spindle 91A. Additionally, the plurality of table supports 92A may extend in different directions from the table spindle 91A. For example, four table supports 92A may extend in left-right and up-down directions, respectively, so as to be arranged perpendicular to each other with respect to the table spindle 91A. The plurality of table supports 92A may include four table supports 92A orthogonal to each other with the table spindle 91A as the center, and the index table 90A may rotate in 90-degree units.

The drawing shows that the table support 92A has a pair of bar shapes extending from the table spindle 91A, but the present invention is not limited thereto. The table support 92A is sufficient if it has a size and shape capable of supporting the solar cell C, and may have a flat plate shape, for example.

The table support 92A may receive the solar cell C from the solar cell supply device 80A and directly support the solar cell C. For example, the solar cell C may be supported on an upper surface of the table support 92A. The table support 92A may include a plurality of suction holes (not shown) or a mechanical clamping unit to support the solar cell C.

The table support 92A may form a stage on which each process for the solar cell C is performed. For example, the table supports 92A may be positioned to correspond to the solar cell alignment device 93A, the solar cell inspection device 94A, the solar cell division device 95A, and the solar cell discharge device 96A, respectively, and may form each stage as a region in which each process, that is, a process of aligning the solar cells C, a process of inspecting the solar cells C, a process of dividing the solar cells C, and a process of discharging the solar cells C is performed. Here, the stage may mean a region in which the corresponding process is performed based on each of the table supports 92A. Additionally, the stage may be a fixed region that does not move along the table support 92A and corresponds to each of the solar cell alignment device 93A, the solar cell inspection device 94A, the solar cell division device 95A, and the solar cell discharge device 96A.

The solar cell alignment device 93A may be positioned to correspond to one of the plurality of table supports 92A and may align the position of the solar cell C delivered from the solar cell supply device 80A. For example, when the solar cell C is delivered from the solar cell supply device 80A and positioned on the table support 92A, the solar cell alignment device 93A may check whether the solar cell C is in a desired position and then correct a position thereof.

As shown in FIG. 11, the solar cell alignment device 93A may be located below the table support 92A and may move the position of the solar cell C located on the table support 92A in the X, Y, and Z-axes directions and adjust an angle around the Z-axis.

The solar cell alignment device 93A may be a robot arm. The solar cell alignment device 93A may correct the position of the solar cell C located on the table support 92A using a vacuum gripper or a finger type gripper.

The solar cell alignment device 93A may include a vision camera and/or sensor to check the position of the solar cell C located on the table support 92A.

The solar cell alignment device 93A may overlap at least a part of the solar cell supply device 80A. For example, as shown in FIGS. 11 and 12, the solar cell supply device 80A may be located above the index table 90A, and the holder 83A adjacent to the index table 90A may overlap at least parts of the solar cell alignment device 93A and the table support 92A corresponding thereto. In this way, when the solar cell alignment device 93A and the solar cell supply device 80A are viewed in a plan view, by overlapping each other, the overall size of the index table 90A, the solar cell supply device 80A, and the tabbing device 1A including the same may be reduced. In addition, the solar cell C may be transferred only by the raising and lowering motions of the solar cell alignment device 93A without the solar cell alignment device 93A and the solar cell supply device 80A having to move toward or away from each other to transfer the solar cell C.

In FIG. 11, the solar cell alignment device 93A is shown as being located below the table support 92A, but the present invention is not limited thereto. The solar cell alignment device 93A may be located above the table support 92A, and a position thereof is not particularly limited as long as it can correct the position of the solar cell C positioned on the table support 92A.

The solar cell inspection device 94A uses a vision camera or the like to inspect the appearance, foreign matter, characteristic recognition, etc., of the solar cell C. The solar cell inspection device 94A forms a 90-degree angle with the solar cell alignment device 93A with the table spindle 91A as the center and may be located, for example, at the bottom right of the solar cell alignment device 93A.

The solar cell inspection device 94A may be position to correspond to another table support 92A that forms a 90-degree angle with the table support 92A corresponding to the solar cell alignment device 93A. Thus, when the index table 90A that receives the solar cell C from the solar cell supply device 80A rotates 90 degrees, the corresponding solar cell C is positioned to correspond to the solar cell inspection device 94A.

The solar cell inspection device 94A is located above or below the table support 92A and inspects a status of the solar cell C using a vision camera or the like. When the solar cell inspection device 94A determines that the solar cell C is a good product, the index table 90A rotates to transfer the solar cell C to a subsequent process, that is, the solar cell division device 95A. When the solar cell inspection device 94A determines that the solar cell C is a defective product, the index table 90A transfers the solar cell C to the solar cell discharge device 96A.

The solar cell division device 95A divides the solar cell C that has been determined to be a good product into a predetermined size. For example, the solar cell division device 95A is a laser scriber that can divide the solar cell C into two or three or more by irradiating the solar cell C with a laser. The solar cell division device 95A may form a 90-degree angle with the solar cell inspection device 94A. For example, the solar cell division device 95A may face the solar cell alignment device 93A with the table spindle 91A as the center and may also be located on the upper right side of the solar cell inspection device 94A.

The solar cell division device 95A may be located in the extension direction of the solar cell alignment device 93A and the wire W. For example, as shown in FIG. 11, a direction in which the solar cell alignment device 93A and the solar cell division device 95A face each other may correspond to a direction in which the wire W located on the wire transfer device 40A extends. The solar cell alignment device 93A and the solar cell division device 95A may be located on opposite sides with the table spindle 91A as the center.

The solar cell division device 95A may be located to correspond to another table support 92A that forms a 90-degree angle with the table support 92A corresponding to the solar cell inspection device 94A. Thus, when the solar cell inspection device 94A determines that the solar cell C is a good product, the index table 90A rotates 90 degrees, and the corresponding solar cell C is positioned to correspond to the solar cell division device 95A. Additionally, the solar cell division device 95A divides the solar cell C that has been determined to be a good product.

On the other hand, when the solar cell inspection device 94A determines that the solar cell C is a defective product, the solar cell division device 95A does not divide the solar cell C even when the solar cell C is positioned to correspond to the solar cell division device 95A. Additionally, when the index table 90A rotates 90 degrees, the corresponding solar cell C moves to the solar cell discharge device 96A.

In addition, the solar cell division device 95A may further include a breaking member for breaking the solar cell C irradiated with a laser along a groove in addition to the laser scriber. For example, the solar cell division device 95A may divide the solar cell C by radiating a laser to the solar cell C, supporting the solar cell C using a vacuum gripper or the like, and then bending the solar cell C centered on the groove. The divided solar cells C may be moved to a subsequent process through the second solar cell transfer device 30A located adjacent to the solar cell division device 95A.

The solar cell alignment device 93A checks and corrects the position of the solar cell C when the transferred solar cell C is positioned on the table support 92A, and the solar cell inspection device 94A inspects whether the position-corrected solar cell C is defective, and the solar cell division device 95A may divide the solar cell C determined to be a good product by the solar cell inspection device 94A into pieces of a predetermined size.

The index table 90A may further include the solar cell discharge device 96A which is located on the side opposite to the solar cell inspection device 94A with the table spindle 91A as the center, and discharges the solar cell C determined to be a defective product to the outside of the tabbing device 1A. When the solar cell inspection device 94A determines that the solar cell C is a good product, the solar cell division device 95A divides the solar cell C, and when the solar cell inspection device 94A determines that the solar cell C is a defective product, the solar cell division device 95A does not divide the solar cell C, and the solar cell discharge device 96A may discharge the solar cell C.

The solar cell discharge device 96A discharges the solar cell C determined to be a defective product to the outside of the tabbing device 1A. For example, when the solar cell inspection device 94A determines that the solar cell C is a defective product, the index table 90A rotates so that the corresponding solar cell C may reach the solar cell discharge device 96A. Then, the solar cell discharge device 96A may discharge the solar cell C to the outside of the tabbing device 1A.

The solar cell discharge device 96A may form a 90-degree angle with the solar cell division device 95A. For example, the solar cell discharge device 96A may be located to face the solar cell inspection device 94A with the table spindle 91A as the center and also located at the upper left of the solar cell division device 95A.

The solar cell discharge device 96A may be located to correspond to another table support 92A that forms a 90-degree angle with the table support 92A corresponding to the solar cell division device 95A. Thus, the solar cell C that is determined to be a defective product and is not divided in the solar cell division device 95A is moved to the solar cell discharge device 96A.

The solar cell discharge device 96A may be perpendicular to the solar cell inspection device 94A and the wire W. For example, as shown in FIG. 11, a direction in which the solar cell discharge device 96A and the solar cell inspection device 94A face each other may extend perpendicularly to a direction in which the wire W located on the wire transfer device 70A extends.

The direction in which the solar cell alignment device 93A and the solar cell division device 95A face each other may be perpendicular to the direction in which the solar cell inspection device 94A and the solar cell discharge device 96A face each other.

The index table 90A may perform each process while rotating at a 90-degree angle. For example, as shown in FIG. 11, the index table 90A may be provided with four table supports 92A extending in directions orthogonal to each other with the table spindle 91A as the center. Further, each of the table supports 92A may be located to correspond to the solar cell alignment device 93A, the solar cell inspection device 94A, the solar cell division device 95A, and the solar cell discharge device 96A. Additionally, the index table 90A may move the solar cells C one after another while rotating at a 90-degree angle.

The index table 90A may perform each process simultaneously for a plurality of solar cells C. For example, when a first solar cell C is transferred from the solar cell supply device 80A to the table support 92A of the index table 90A, the solar cell alignment device 93A corrects the position of the solar cell C. Then, the index table 90A rotates 90 degrees to move the corresponding solar cell C to the solar cell inspection device 94A. At the same time or with a slight time difference, a second solar cell C is transferred from the solar cell supply device 80A to the table support 92A corresponding to the solar cell alignment device 93A. Again, the index table 90A rotates 90 degrees to move the first solar cell C to the solar cell division device 95A and the transferred second solar cell C to the solar cell inspection device 94A. Here, when the first solar cell C is determined to be a good product, the divided solar cell C is transferred by the second solar cell transfer device 30A. At the same time or with a slight time difference, a third solar cell C is delivered from the solar cell supply device 80A to the table support 92A corresponding to the solar cell alignment device 93A. Again, the index table 90A rotates 90 degrees, and when the first solar cell C is determined to be a good product, the empty table support 92A is located at the solar cell discharge device 96A, the second solar cell C moves to the solar cell division device 95A, and the third solar cell C moves to the solar cell inspection device 94A. When the first solar cell C is determined to be a defective product, the corresponding solar cell C is delivered to the solar cell discharge device 96A and is discharged to the outside of the tabbing device 1A. At the same time or with a slight time difference, a fourth solar cell C is transferred from the solar cell supply device 80A to the table support 92A corresponding to the solar cell alignment device 93A. Again, the index table 90A rotates 90 degrees so that the table support 92A that supported the first solar cell C is located to correspond to the solar cell alignment device 93A.

When one solar cell C is supplied to the index table 90A, the index table 90A may not receive another solar cell C until the process for the corresponding solar cell C is completed. Here, "completion of the process" means that the solar cell C determined to be a good product is divided and transferred to the second solar cell transfer device 30A, or the solar cell C determined to be a defective product is discharged to the outside of the tabbing device 1A through the solar cell discharge device 96A.

Next, the tabbing method and the operation of the index table 90A will be described with reference to FIGS. 13 to 17.

Before the operation of supporting the solar cell C and wire jig J of one set, the tabbing method described above may further include an operation in which the solar cell supply device 80A transfers the solar cell C from the first solar cell transfer device 20A to the index table 90A, an operation in which the solar cell alignment device 93A aligns the solar cell C, an operation in which the solar cell inspection device 94A inspects the aligned solar cell C to determine whether the solar cell C is a good or defective product, an operation in which the solar cell division device 95A divides the solar cell C determined to be a good product, and an operation of sequentially moving the solar cell C to the solar cell alignment device 93A, the solar cell inspection device 94A, and the solar cell division device 95A located to correspond to the plurality of table supports 92A of the index table 90A while the index table 90A rotates at a predetermined angle between the operations of aligning the solar cells C, inspecting the solar cell C and dividing the solar cell C.

At least two of the operations of aligning the solar cell C, inspecting the solar cell C, and dividing the solar cell C may be performed simultaneously.

An operation in which the solar cell discharge device 96A of the index table 90A discharges the solar cell C to the outside when the solar cell C is determined to be a defective product in the operation of inspecting the solar cell C may be further included.

As shown in FIG. 13, the solar cell C is transferred from the first solar cell transfer device 20A to the solar cell supply device 80A. The first solar cell transfer devices 20A are respectively located above and below the solar cell supply device 80A. The solar cell supply device 80A may be located so that the holder 83A corresponds to the solar cell C positioned at an end portion of each of the first solar cell transfer devices 20A and supports the solar cell C in this state. For example, as shown in FIG. 13, the holders 83A respectively located above and below the solar cell supply device 80A may support the solar cells C. Here, the solar cell C supported by the holder 83A located below the solar cell supply device 80A based on FIG. 13 is referred to as a first solar cell C1.

Next, as shown in FIG. 14, the solar cell supply device 80A rotates 90 degrees counterclockwise around the support shaft 81A. Thus, the first solar cell C1 supported by the holder 83A located below the solar cell supply device 80A moves to the right side of the solar cell supply device 80A. Additionally, as shown in FIGS. 12 and 14, the holder 83A may be located to correspond to the left table support 92A of the index table 90A. Then, the holder 83A may be lowered to position the first solar cell C1 on the table support 92A.

Additionally, the position of the first solar cell C1 may be corrected through the solar cell alignment device 93A of the index table 90A. For example, the solar cell alignment device 93A checks the position of the first solar cell C1 positioned on the table support 92A through a vision camera or the like, and moves and rotates to correct the position of the first solar cell C1 when a current position of the first solar cell C1 deviates from a preset position.

Then, the empty holder 83A of the solar cell supply device 80A supports the solar cell C located on the first solar cell transfer device 20A. Here, the solar cell C supported by the holder 83A located below the solar cell supply device 80A based on FIG. 14 is referred to as a second solar cell C2.

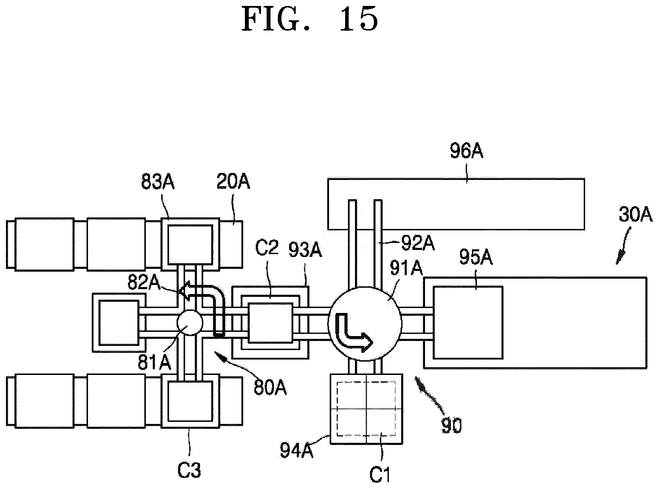

Next, as shown in FIG. 15, when the position alignment of the first solar cell C1 is completed, the index table 90A rotates 90 degrees counterclockwise. Thus, the first solar cell C1 moves to a position corresponding to the solar cell inspection device 94A. The solar cell inspection device 94A uses a vision camera or the like to check the appearance, shape, size, product number, and the like of the first solar cell C1 and detects defective conditions. In addition, the solar cell alignment device 93A performs the alignment process in the same manner for the second solar cell C2.

Additionally, the solar cell supply device 80A rotates 90 degrees counterclockwise again and the empty holder 83A supports the solar cell C located on the first solar cell transfer device 20A. Here, the solar cell C supported by the holder 83A located below the solar cell supply device 80A based on FIG. 15 is called a third solar cell C3.

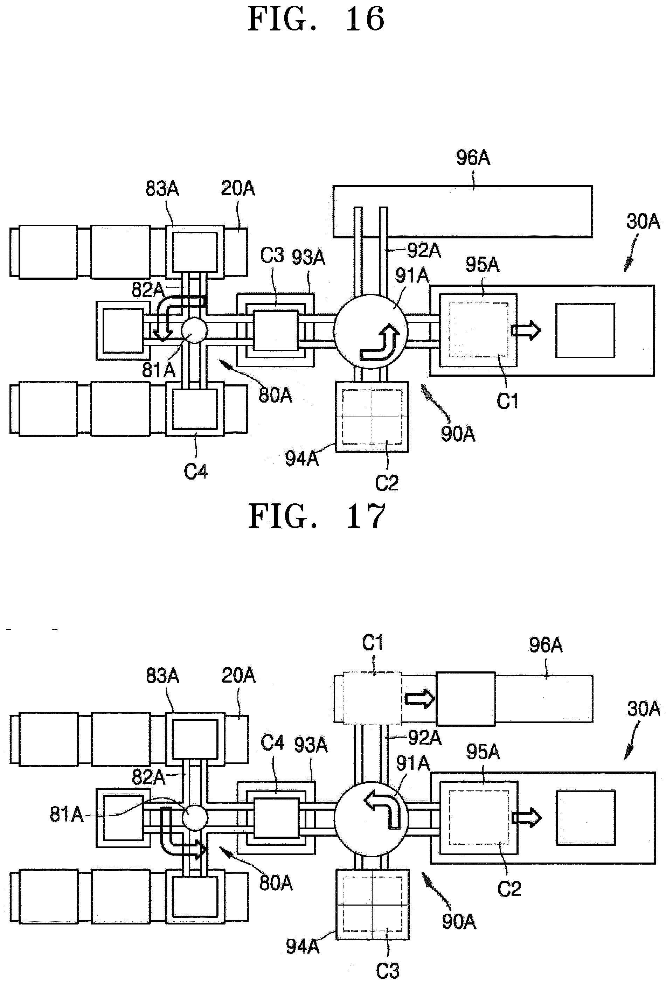

Next, as shown in FIG. 16, the index table 90A rotates 90 degrees counterclockwise again to move the first solar cell C1 to a position corresponding to the solar cell division device 95A. Here, when the solar cell inspection device 94A determines that the first solar cell C1 is a good product, the solar cell division device 95A divides the first solar cell C1 into pieces of a predetermined size and number. The divided first solar cell C1 may be transferred to the second solar cell transfer device 30A. On the other hand, when the solar cell inspection device 94A determines that the first solar cell C1 is a defective product, the solar cell division device 95A does not perform a dividing process on the first solar cell C1, and the first solar cell C1 remains in a state in which it is supported on the table support 92A.

Additionally, the solar cell inspection device 94A performs an inspection process on the second solar cell C2, and the solar cell alignment device 93A performs an alignment process on the third solar cell C3.

Additionally, the solar cell supply device 80A rotates 90 degrees counterclockwise again and the empty holder 83A supports the solar cell C located on the first solar cell transfer device 20A. Here, the solar cell C supported by the holder 83A below the solar cell supply device 80A based on FIG. 16 is referred to as a fourth solar cell C4.

Next, as shown in FIG. 17, the index table 90A rotates 90 degrees counterclockwise again to move the first solar cell C1 to a position corresponding to the solar cell discharge device 96A. Here, when the solar cell inspection device 94A determines that the first solar cell C1 is a good product, since the first solar cell C1 is divided by the solar cell division device 95A and transferred through the second solar cell transfer device 30A, the table support 92A becomes empty. On the other hand, when the solar cell inspection device 94A determines that the first solar cell C1 is a defective product, the solar cell discharge device 96A receives the first solar cell C1 and discharges the first solar cell C1 to the outside of the tabbing device 1.

In addition, the solar cell division device 95A performs a dividing process when the second solar cell C2 is determined to be a good product, the solar cell inspection device 94A performs an inspection process on the third solar cell C3, and the solar cell alignment device 93A performs an alignment process on the fourth solar cell C4.

Additionally, the solar cell supply device 80A rotates 90 degrees counterclockwise again and the empty holder 83A supports the solar cell C positioned in the first solar cell transfer device 20A.

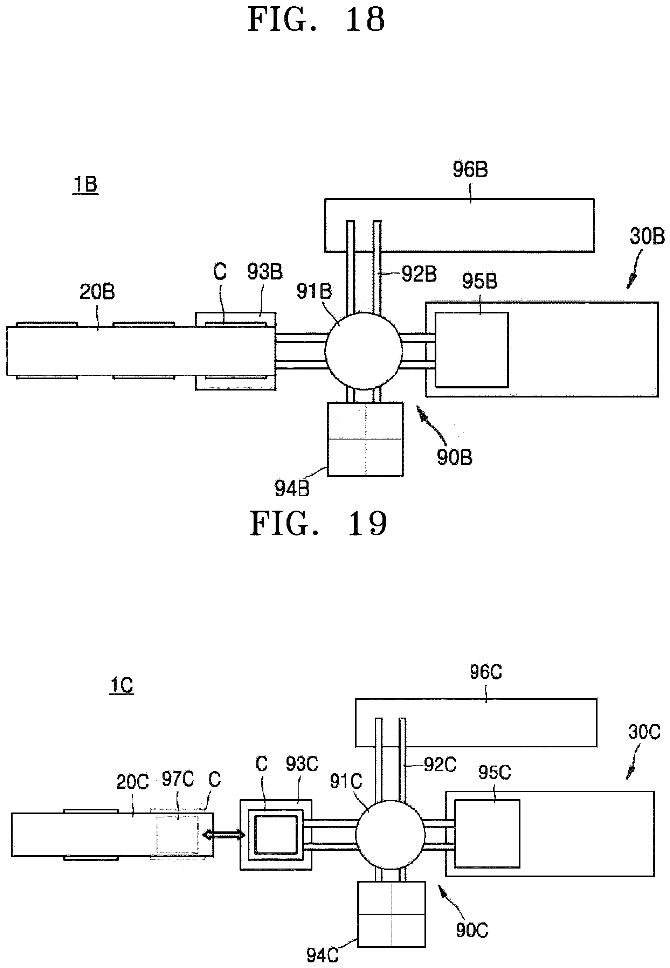

A tabbing device 1B is described with reference to FIG. 18.

FIG. 18 shows a part of the tabbing device 1B including another type of first solar cell transfer device 20B and not including the solar cell supply device 80A. Other configurations of the tabbing device 1B may be the same as those of the tabbing device 1A described above, and a detailed description thereof will be omitted.

As shown in FIG. 18, the first solar cell transfer device 20B may transfer a solar cell C directly to an index table 90B without going through the solar cell supply device 80A. The first solar cell transfer device 20B may be located so that an end portion thereof corresponds to a left support 92B of the index table 90B and a solar cell alignment device 93B. When the solar cell C is transferred from the first solar cell transfer device 20B to the support 92B, the solar cell alignment device 93B may correct a position thereof. Once the position correction is completed, the index table 90B may rotate 90 degrees to transfer the corresponding solar cell C to a solar cell inspection device 94B. Then, a subsequent solar cell C transferred from the first solar cell transfer device 20B may be transferred to the solar cell alignment device 93B.

A tabbing device 1C is described with reference to FIG. 19.

FIG. 19 shows a part of the tabbing device 1C including another type of index table 90C and not including the solar cell supply device 80A. Other configurations of the tabbing device 1C may be the same as those of the tabbing device 1C described above, and a detailed description thereof will be omitted.

As shown in FIG. 19, a first solar cell transfer device 20C is a conveyor device that moves a solar cell C in one direction and may be spaced apart from the index table 90C. That is, an end portion of the first solar cell transfer device 20C may not overlap a left support 92C of the index table 90C and a solar cell alignment device 93C.

Additionally, the index table 90C may further include a transfer robot 97C. The transfer robot 97C is located on the support 92C corresponding to the solar cell alignment device 93C. The transfer robot 97C may transfer the solar cell C from the first solar cell transfer device 20C to the index table 90C, while moving between the solar cell alignment device 93C and the first solar cell transfer device 20C. For example, the transfer robot 97C may support the solar cell C by suction through an suction hole or may support the solar cell C with a mechanical clamping unit to position the solar cell C on the support 92C.

Although the present invention has been described with reference to the embodiments illustrated in the drawings, these are merely examples. Anyone skilled in the art will readily appreciate that various modifications and equivalent other embodiments are possible from the embodiments. Therefore, the true technical protection scope of the present invention should be determined based on the appended claims.

### [Industrial Applicability]

The present invention can be used in industries related to a tabbing device and a tabbing method.

## Claims

1. A tabbing device comprising:
a stage configured to support a solar cell and a wire jig;
a wire jig transfer device configured to transfer the wire jig to the stage;
a wire transfer device adjacent to the wire jig transfer device and configured to transfer a wire; and
a cell-jig transfer device configured to position the solar cell and the wire jig on the wire supported by the wire transfer device,
wherein the cell-jig transfer device includes a body spindle, and a plurality of bodies which are rotated by the body spindle, support the solar cell and the wire jig on the stage, and position the solar cell and the wire jig on the wire on the wire transfer device, and
the plurality of bodies alternately perform an operation of supporting the solar cell and the wire jig while rotating around the body spindle, and an operation of positioning the solar cell and the wire jig on the wire.

2. The tabbing device of claim 1, wherein each of the plurality of bodies supports a solar cell and wire jig of a different set.

3. The tabbing device of claim 1, wherein the cell-jig transfer device positions any one of the plurality of bodies above the stage and the other above the wire transfer device, and
when one body supports the solar cell and the wire jig on the stage, the other body simultaneously positions the solar cell and the wire jig on the wire on the wire transfer device.

4. The tabbing device of claim 1, wherein the plurality of bodies include a first body and a second body which face each other with the body spindle as a center,
the first body and the second body support different sets of solar cells and wire jigs, and
when the first body positions a solar cell and wire jig of one set on the wire, the second body simultaneously supports a solar cell and wire jig of another set positioned on the stage.

5. The tabbing device of claim 1, wherein each of the plurality of bodies simultaneously supports a solar cell and wire jig of one set, or simultaneously positions a solar cell and wire jig of one set on the wire.

6. The tabbing device of claim 1, comprising:
an index table including a table spindle and a plurality of table supports configured to rotate around the table spindle;
a first solar cell transfer device configured to transfer the solar cell to the index table; and
a solar cell supply device configured to transfer the solar cell from the first solar cell transfer device to the index table,
wherein the index table includes a solar cell alignment device, a solar cell inspection device, and a solar cell division device which are located to correspond to the plurality of table supports, respectively, and
the index table moves the solar cell transferred from the first solar cell transfer device to the solar cell alignment device, the solar cell inspection device, and the solar cell division device, while rotating at a predetermined angle.

7. The tabbing device of claim 6, wherein the first solar cell transfer device transfers the solar cell to a table support corresponding to the solar cell alignment device among the plurality of table supports, and
the index table sequentially moves the solar cell to the solar cell inspection device and the solar cell division device while rotating around the table spindle.

8. The tabbing device of claim 6, wherein when the solar cell alignment device completes an alignment process, the index table rotates to move the aligned solar cell to the solar cell inspection device, and the first solar cell transfer device moves the solar cell to a support corresponding to the solar cell alignment device.

9. The tabbing device of claim 6, wherein the index table supports one or more solar cells simultaneously, and
at least two of the solar cell alignment device, the solar cell inspection device, and the solar cell division device operate simultaneously.

10. The tabbing device of claim 6, wherein the plurality of table supports include four table supports orthogonal to each other with the table spindle as the center, and
the index table rotates in 90 degree units.

11. The tabbing device of claim 6, wherein the solar cell alignment device checks and corrects a position of the solar cell when the transferred solar cell is positioned on the table support,
the solar cell inspection device inspects whether the position-corrected solar cell is defective, and
the solar cell division device divides the solar cell determined to be a good product by the solar cell inspection device into a predetermined size.

12. The tabbing device of claim 11, wherein the index table further includes a solar cell discharge device located on a side opposite to the solar cell inspection device with the table spindle as the center, and configured to discharge the solar cell determined to be a defective product to the outside of the tabbing device,
when the solar cell inspection device determines that the solar cell is a good product, the solar cell division device divides the solar cell, and
when the solar cell inspection device determines that the solar cell is a defective product, the solar cell division device does not divide the solar cell, and the solar cell discharge device discharges the solar cell.

13. The tabbing device of claim 6, wherein the solar cell alignment device and the solar cell division device are located on opposite sides with the table spindle as the center.

14. The tabbing device of claim 6, wherein the solar cell supply device includes:
a support shaft;
a plurality of support frames configured to extend in different directions from the support shaft; and
a plurality of holders respectively connected to the plurality of support frames to support the solar cells, and
any one of the plurality of holders overlaps any one of the plurality of table supports of the index table.

15. The tabbing device of claim 14, wherein the first solar cell transfer device includes two first solar cell transfer devices each corresponding to the solar cell supply device, and
the plurality of support frames include four support frames orthogonal to each other with the support shaft as the center, and support simultaneously two solar cells transferred from the first solar cell transfer device.

16. A tabbing method comprising:
supporting a solar cell and wire jig of one set supported on a stage with any one body by a cell-jig transfer device including a plurality of bodies;
positioning the supported solar cell and wire jig of one set on a wire located on a wire transfer device by rotating the cell-jig transfer device; and
supporting a solar cell and wire jig of another set supported on the stage with another body of the plurality of bodies by the cell-jig transfer device,
wherein the supporting of the solar cell and the wire jig and the positioning of the solar cell and the wire jig on the wire are repeated.

17. The tabbing method of claim 16, wherein the transferring of the solar cell and the wire jig and the positioning of the solar cell and the wire jig on the wire are performed simultaneously.

18. The tabbing method of claim 16, further comprising:
before the supporting of the solar cell and wire jig of one set,
delivering a solar cell from a first solar cell transfer device to an index table by a solar cell supply device;
aligning the solar cell by a solar cell alignment device;
inspecting the aligned solar cell to determine whether the solar cell is a good product or a defective product by a solar cell inspection device;
dividing the solar cell determined to be a good product by a solar cell division device; and
sequentially moving the solar cell to the solar cell alignment device, the solar cell inspection device, and the solar cell division device located to correspond to a plurality of table supports of the index table, while the index table is rotated at a predetermined angle, between the aligning of the solar cell, the inspecting of the solar cell, and the dividing of the solar cell.

19. The tabbing method of claim 18, wherein at least two of the aligning of the solar cell, the inspecting of the solar cell, and the dividing of the solar cell are performed simultaneously.

20. The tabbing method of claim 18, further comprising discharging the solar cell to the outside by a solar cell discharge device of the index table when the solar cell is determined to be a defective product in the inspecting of the solar cell.
